# EUROPEAN PATENT APPLICATION

(11) **EP 4 664 522 A1**
(43) Date of publication of application: **17.12.2025**
(21) Application number: 25180740.0
(22) Date of filing: 04.06.2025
(51) Int. Cl.: H01L 23/373, H05K 1/18, H05K 1/02, H01L 23/31, H01L 23/552

(54) **THERMAL MANAGEMENT SYSTEMS AND METHODS FOR SEMICONDUCTOR DEVICES**

(30) Priority: 12.06.2024 US 202463658964 P; 10.09.2024 US 202418830319
(71) Applicant: Avago Technologies International Sales Pte. Limited, Singapore 768923 (SG)
(72) Inventor: Ruby, Richard, San Jose, CA, 95131 (US); Sun, Li, San Jose, CA, 95148 (US); Wang, Wei-Shun, San Jose, CA, 95131 (US); Wu, Qifeng, San Jose, CA, 95131 (US); Wade, Christopher, Los Gatos, CA, 95032 (US); Chung, Chris, San Jose, CA, 95120 (US); Leary, Michael H., San Jose, CA, 95131 (US)
(74) Representative: Grünecker Patent- und Rechtsanwälte PartG mbB

(57) **Abstract**

The subject technology is directed to a semiconductor device. In an embodiment, the semiconductor device comprises an interposer, which comprises a first side and a second side. The first side is opposite the second side. The device further comprises a first circuit coupled to the first side and a second circuit coupled to the second side. The device further comprises a first layer coupled to the first circuit and a second layer coupled to the second circuit. The second layer is configured to dissipate heat generated by the second circuit. This configuration enhances thermal management by providing a direct thermal path for heat dissipation, improving the overall efficiency and reliability of the semiconductor device. Additionally, the elimination of thermal vias simplifies the PCB layout, allowing for more compact and cost-effective designs.

## Description

### CROSS REFERENCE TO RELATED APPLICATIONS

This application claims priority to U.S. Provisional Application No. 63/658,964, filed June 12, 2024, which is commonly owned and incorporated by reference herein for all purposes.

### FIELD OF INVENTION

The subject technology is directed to semiconductor devices.

### BACKGROUND OF THE INVENTION

Efficient thermal management is important for the performance and reliability of semiconductor devices, particularly those used in high-power applications. Over the past decade, the demand for more powerful and compact electronic devices has driven the need for advanced thermal management solutions. Some approaches involve using thermal vias for heat dissipation, which are often inadequate due to their limited thermal conductivity and the complexity they introduce in the printed circuit board (PCB) layout. These methods struggle to provide efficient thermal pathways, leading to potential overheating and reduced reliability of semiconductor components.

Various approaches for improving thermal management in semiconductor devices have been explored, but they are often insufficient. It is important to recognize the need for new and improved thermal management methods and systems.

### BRIEF DESCRIPTION OF THE DRAWINGS

A further understanding of the nature and advantages of particular embodiments may be realized by reference to the remaining portions of the specification and the drawings, in which like reference numerals are used to refer to similar components. In some instances, a sub-label is associated with a reference numeral to denote one of multiple similar components. When reference is made to a reference numeral without specification to an existing sub-label, it is intended to refer to all such multiple similar components.
Figure 1 is a schematic cross-sectional view of a semiconductor device, in accordance with various embodiments of the subject technology.
Figure 2 is a schematic cross-sectional view of a semiconductor device, in accordance with various embodiments of the subject technology.
Figure 3 is a schematic cross-sectional view of a semiconductor device, in accordance with various embodiments of the subject technology.
Figure 4 is a schematic cross-sectional view of a semiconductor device, in accordance with various embodiments of the subject technology.
Figure 5 is a schematic cross-sectional view of a semiconductor device, in accordance with various embodiments of the subject technology.
Figure 6 is a schematic cross-sectional view of a semiconductor device, in accordance with various embodiments of the subject technology.
Figure 7 is a schematic cross-sectional view of a semiconductor device, in accordance with various embodiments of the subject technology.
Figure 8 is a schematic cross-sectional view of a semiconductor device, in accordance with various embodiments of the subject technology.

### DETAILED DESCRIPTION OF THE INVENTION

The subject technology is directed to a semiconductor device and methods thereof. In an embodiment, the semiconductor device comprises an interposer, which comprises a first side and a second side. The first side is opposite the second side. The device further comprises a first circuit coupled to the first side and a second circuit coupled to the second side. The device further comprises a first layer coupled to the first circuit and a second layer coupled to the second circuit. The second layer is configured to dissipate heat generated by the second circuit. This configuration enhances thermal management by providing a direct thermal path for heat dissipation, improving the overall efficiency and reliability of the semiconductor device. Additionally, the elimination of thermal vias simplifies the PCB layout, allowing for more compact and cost-effective designs.

The following description is presented to enable one of ordinary skill in the art to make and use the invention and to incorporate it in the context of particular applications. Various modifications, as well as a variety of uses in different applications will be readily apparent to those skilled in the art, and the general principles defined herein may be applied to a wide range of embodiments. Thus, the subject technology is not intended to be limited to the embodiments presented but is to be accorded the widest scope consistent with the principles and novel features disclosed herein.

In the following detailed description, numerous specific details are set forth in order to provide a more thorough understanding of the subject technology. However, it will be apparent to one skilled in the art that the subject technology may be practiced without necessarily being limited to these specific details. In other instances, well-known structures and devices are shown in block diagram form, rather than in detail, in order to avoid obscuring the subject technology.

The reader's attention is directed to all papers and documents which are filed concurrently with this specification and which are open to public inspection with this specification, and the contents of all such papers and documents are incorporated herein by reference. All the features disclosed in this specification, (including any accompanying claims, abstract, and drawings) may be replaced by alternative features serving the same, equivalent, or similar purpose, unless expressly stated otherwise. Thus, unless expressly stated otherwise, each feature disclosed is one example only of a generic series of equivalent or similar features.

Furthermore, any element in a claim that does not explicitly state "means for" performing a specified function, or "step for" performing a specific function, is not to be interpreted as a "means" or "step" clause as specified in 35 U.S.C. Section 112, Paragraph 6. In particular, the use of "step of" or "act of" in the Claims herein is not intended to invoke the provisions of 35 U.S.C. 112, Paragraph 6.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

When an element is referred to herein as being "disposed" in some manner relative to another element (e.g., disposed on, disposed between, disposed under, disposed adjacent to, or disposed in some other relative manner), it is to be understood that the elements can be directly disposed relative to the other element (e.g., disposed directly on another element), or have intervening elements present between the elements. In contrast, when an element is referred to as being "disposed directly" relative to another element, it should be understood that no intervening elements are present in the "direct" example. However, the existence of a direct disposition does not exclude other examples in which intervening elements may be present.

Similarly, when an element is referred to herein as being "bonded" to another element, it is to be understood that the elements can be directly bonded to the other element (without any intervening elements) or have intervening elements present between the bonded elements. In contrast, when an element is referred to as being "directly bonded" to another element, it should be understood that no intervening elements are present in the "direct" bond between the elements. However, the existence of direct bonding does not exclude other forms of bonding, in which intervening elements may be present.

Likewise, when an element is referred to herein as being a "layer," it is to be understood that the layer can be a single layer or include multiple layers. For example, a conductive layer may comprise multiple different conductive materials or multiple layers of different conductive materials, and a dielectric layer may comprise multiple dielectric materials or multiple layers of dielectric materials. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of" preceding a series of items, with the term "and" or "or" to separate any of the items, modifies the list as a whole, rather than each member of the list (i.e., each item). The phrase "at least one of" does not require selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

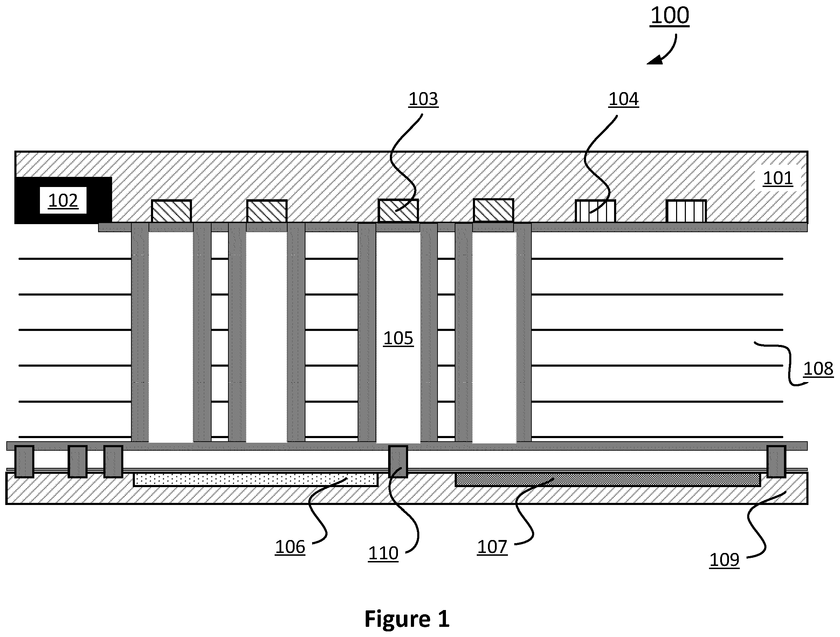

Figure 1 is a schematic cross-sectional view of a semiconductor device 100, in accordance with various embodiments of the subject technology. This diagram merely provides an example, which should not unduly limit the scope of the claims. One of ordinary skill in the art would recognize many variations, alternatives, and modifications.

Semiconductor device 100 may include a semiconductor module designed for various applications, such as radio frequency (RF) communication, data processing, power management, and/or the like. For instance, in an RF application, the semiconductor module may be configured to manage signal transmission and reception, noise filtering, signal amplification, and/or the like. In some implementations, the semiconductor module may be a double-sided module, which may refer to an assembly where components are mounted on both the top and bottom surfaces of a substrate. This configuration allows for compact and efficient use of space, which is advantageous in high-performance, space-constrained applications such as mobile devices, industrial automation, and consumer electronics.

As shown, semiconductor device 100 includes interposer 108. For example, the term "interposer" may refer to a layer that facilitates the electrical connection and mechanical support between different components within a semiconductor device. Interposers may be made from various materials and may serve various functions such as signal routing, power distribution, and thermal management. Examples of interposers may include, without limitation, PCBs, low-temperature co-fired ceramics (LTCC), high-temperature co-fired ceramics (HTCC), semiconductor materials such as silicon (Si) or gallium arsenide (GaAs), and/or the like. Interposer 108 includes a first side and a second side. The first side may be positioned opposite to the second side. For purposes of this description, the first side may also be referred to as the top side, upper side, or upper surface. The second side may be referred to as the bottom side, lower side, underside, or backside. These terms are used interchangeably throughout this description to describe various embodiments and are not intended to limit the scope of the subject technology.

In some implementations, semiconductor device 100 further includes surface-mount technology (SMT) component 102. For instance, the term "SMT component" may refer to an electronic device that is mounted directly onto the surface of a substrate or interposer without the need for through-hole connections to achieve electrical or mechanical bonding. SMT component 102 may include, without limitation, resistors, capacitors, diodes, transistors, inductors, filters, and/or the like. In some cases, SMT component 102 may be coupled to the first side of interposer 108. It should be noted that the inclusion of SMT component 102 is not required in every embodiment and may vary depending on the design requirements. Accordingly, the claims do not limit the semiconductor device to embodiments including SMT components.

According to some embodiments, semiconductor device 100 further includes first circuit 104 coupled to the first side of interposer 108. For instance, the term "circuit" may refer to an arrangement of electronic components designed to perform a specific function or set of functions. Examples of circuits may include, without limitation, amplifier circuits, oscillator circuits, filter circuits, switching circuits, signal processing circuits, and/or the like. In some cases, a circuit may include a die or a part of a die. The term "die" may refer to a small piece of semiconductor material on which a functional circuit is fabricated. In various examples, first circuit 104 may include a first RF component. The term "RF component" may refer to any electronic component or circuit used in radio frequency applications to process or control RF signals. Examples of RF components may include, without limitation, filter circuits (e.g., bandpass filters, high-pass filters, low-pass filters), low noise amplifier (LNA) circuits, power amplifier (PA) circuits, switch circuits, coupler circuits, logic circuits, transmit filters, receive filters, power amplifiers, antennas, band select switches, and/or the like. In some examples, first circuit 104 includes a receive (Rx) filter. The term "receive filter" may refer to an electronic filter designed to receive and process incoming signals within a specified frequency range while rejecting unwanted signals. Examples of Rx filters may include, without limitation, bandpass filters, high-pass filters, low-pass filters, surface acoustic wave (SAW) filters, bulk acoustic wave (BAW) filters, film bulk acoustic resonator (FBAR) filters, solidly mounted resonator bulk acoustic wave (SMRBAW) filters, silicon-based surface acoustic wave (SiSAW) filters, temperature compensated surface acoustic wave (TCSAW) filters, dielectric filters, and/or the like. Receive filters function to isolate the desired signal from a range of received signals, ensuring that the signal quality is maintained for further processing.

In various embodiments, semiconductor device 100 further includes layer 101, which may be coupled to first circuit 104. For instance, layer 101 includes a molding material. The term "molding material" may refer to an encapsulating material used to protect and insulate electronic components. Examples of molding materials may include, without limitation, epoxy molding compounds (EMC), silicone molding compounds (SMC), phenolic molding compounds, polyimide molding compounds, and/or the like. Molding materials may be used to encapsulate electronic components (e.g., first circuit 104, second circuit 103), protecting them from physical damage, moisture, dust, and other environmental factors.

In various examples, semiconductor device 100 further includes second circuit 103 coupled to the first side of interposer 108. Second circuit 103 may include an RF component. For example, second circuit 103 may include, without limitation, a transmit (Tx) filter, a time-division duplexing (TDD) filter, an amplifier, and/or the like. The term "transmit filter" may refer to an electronic filter designed to pass signals of a particular frequency range while blocking unwanted frequencies during transmission. Examples of Tx filters may include, without limitation, bandpass filters, high-pass filters, low-pass filters, SAW filters, BAW filters, FBAR filters, SMRBAW filters, SiSAW filters, TCSAW filters, dielectric filters, and/or the like. Tx filters function to shape and limit the bandwidth of the transmitted signal to ensure it complies with regulatory standards and minimizes interference with other signals.

In various examples, semiconductor device 100 further includes substrate 109, which may be coupled to the second side of interposer 108 through interconnect 110. For example, the term "substrate" may refer to the base layer that supports and electrically connects the various components of a semiconductor device. Substrate 109 may function as a motherboard or include a ground paddle that is part of a motherboard, providing a stable platform for mounting and connecting components. The term "interconnect" may refer to a structure or mechanism that electrically connects two or more layers or components in a semiconductor device. Interconnect 110 may include, without limitation, metal traces, solder bumps, conductive adhesives, wire bonds, through-silicon vias (TSVs), and/or the like. Depending on the implementation, substrate 109 may be considered part of semiconductor device 100 or serve as a separate component providing mechanical support and electrical connectivity for semiconductor device 100. For instance, substrate 109 may include, without limitation, PCBs, silicon wafers, ceramic substrates, and/or the like.

Substrate 109 also plays a role in thermal management by helping to dissipate heat generated by the components on interposer 108. It may include thermal pads or heat sinks to aid in efficient heat dissipation. The integration of high-power components (e.g., first circuit 104, second circuit 103) on the first side of interposer 108 necessitates effective thermal management to ensure optimal performance and reliability. For instance, the term "high-power" may refer to components that handle significant power levels (e.g., in the range of several watts to tens of watts), resulting in substantial heat generation. In some cases, this may refer to components designed to operate at power levels 20-50% higher than standard low-power circuits. In various implementations, first circuit 104 and second circuit 103 may be 200 to 250 um thick, which adds to the challenge of managing thermal dissipation when both circuits are placed on the same side (e.g., the first side). The close proximity of these high-power components can lead to localized hotspots, exacerbating the thermal resistance issue. Inadequate heat dissipation can lead to increased thermal resistance, affecting the efficiency and longevity of the device.

Some approaches for thermal management involve the use of thermal vias and thermal pads to conduct heat away from the heat-generating components (e.g., first circuit 104, second circuit 103) and transfer it to the motherboard thermal ground (e.g., substrate 109). For instance, semiconductor device 100 further comprises via 105. The term "via" or "thermal via" may refer to a conductive pathway that connects different layers of a substrate. In some examples, via 105 extends through interposer 108, providing an electrical and thermal connection between the first side and the second side of interposer 108. This connection helps conduct heat away from the high-power components to the other side of the substrate, where it can be more effectively dissipated.

For maximum heat transfer, via 105 must be positioned directly under second circuit 103. In some cases, additional interconnects (e.g., interconnect 110) on the backside of the module may be needed to provide better thermal anchoring for any residual heat generated by second circuit 103. However, this approach has limitations. The thermal conductivity of via 105 is limited by its material properties and cross-sectional area, which may restrict the amount of heat that can be effectively transferred. Additionally, integrating thermal vias into the PCB layout introduces complexity, as it requires precise placement and adequate spacing to avoid electrical interference and maintain structural integrity. Despite using thermal vias, the overall thermal resistance may still be high, affecting the efficiency of heat dissipation and potentially impacting the performance and reliability of semiconductor device 100.

Depending on the application, semiconductor device 100 may further include third circuit 106, which may be coupled to interposer 108. For instance, third circuit 106 includes a low-noise amplifier (LNA). The term "low-noise amplifier" may refer to a type of electronic amplifier designed to amplify weak electrical signals while introducing minimal additional noise. LNAs function to improve the sensitivity of the receiver by amplifying the received signal without significantly degrading the signal-to-noise ratio (SNR), thereby enhancing the overall performance of the communication system.

In some embodiments, third circuit 106 includes a mobile industry processor interface (MIPI) controller. The term "MIPI controller" may refer to a component that facilitates highspeed communication between the main processor and peripheral components (e.g., cameras, displays, sensors, etc.) in mobile devices. The MIPI controller manages the data transfer between these components, ensuring efficient and reliable communication.

In various implementations, semiconductor device 100 further includes fourth circuit 107, which may be coupled to interposer 108. For instance, fourth circuit 107 may include a switch. The term "switch" or "switch circuit" may refer to an electronic component that controls the flow of electrical signals within a circuit. Fourth circuit 107 may include, without limitation, RF switches, power switches, signal switches, and/or the like. Fourth circuit 107 allows for the selection between different signal paths, enabling the device to switch between antennas, frequency bands, or communication standards as needed. This flexibility is beneficial in modern communication systems where devices operate across multiple frequency bands and standards (e.g., 4G, 5G, Wi-Fi, Bluetooth, etc.).

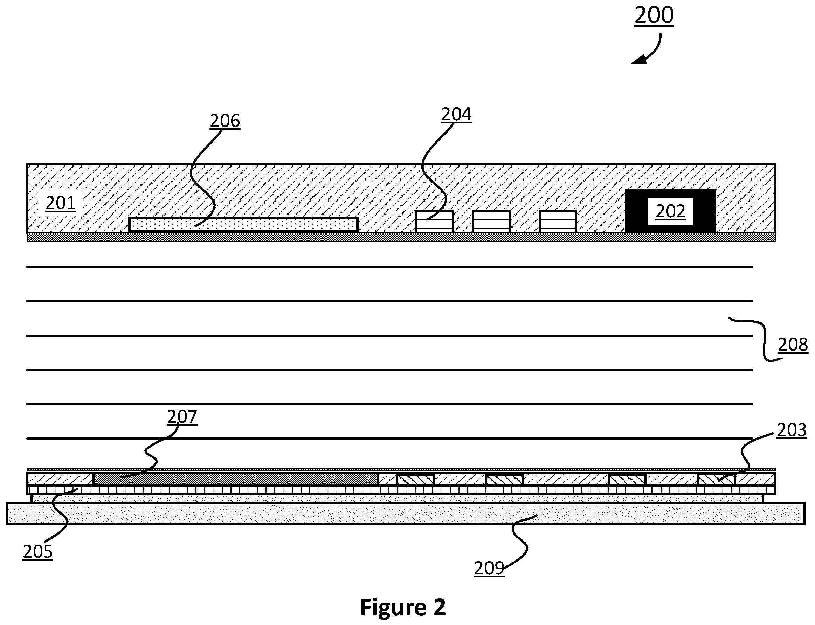

Figure 2 is a schematic cross-sectional view of a semiconductor device 200, in accordance with various embodiments of the subject technology. This diagram merely provides an example, which should not unduly limit the scope of the claims. One of ordinary skill in the art would recognize many variations, alternatives, and modifications. In various embodiments, semiconductor device 200 may include at least one of layer 201, SMT component 202, first circuit 204, second circuit 203, layer 205, third circuit 206, fourth circuit 207, interposer 208, substrate 209, and/or the like.

Similar to semiconductor device 100 of Figure 1, interposer 208 includes a first side and a second side. The first side may be opposite the second side. First circuit 204 may be coupled to the first side of interposer 208. First circuit 204 may include an RF component. In some examples, first circuit 204 includes an Rx filter, which may be configured to isolate the desired signal from a range of received signals, ensuring that the signal quality is maintained for further processing. Examples of Rx filters may include, without limitation, bandpass filters, high-pass filters, low-pass filters, SAW filters, BAW filters, FBAR filters, SMRBAW filters, SiSAW filters, TCSAW filters, dielectric filters, and/or the like.

In various embodiments, layer 201 may be coupled to first circuit 204. For instance, layer 201 includes a molding material, which may be configured to encapsulate first circuit 204, protecting it from physical damage, moisture, dust, and other environmental factors. Examples of molding materials may include, without limitation, EMC, SMC, phenolic molding compounds, polyimide molding compounds, and/or the like.

As shown in Figure 2, second circuit 203 is coupled to the second side of interposer 208. Second circuit 203 may include an RF component. For example, second circuit 203 may include, without limitation, a Tx filter, a time-division duplexing (TDD) filter, an amplifier, and/or the like. Examples of Tx filters may include, without limitation, bandpass filters, high-pass filters, low-pass filters, SAW filters, BAW filters, FBAR filters, SMRBAW filters, SiSAW filters, TCSAW filters, dielectric filters, and/or the like. Tx filters function to shape and limit the bandwidth of the transmitted signal to ensure it complies with regulatory standards and minimizes interference with other signals.

By positioning second circuit 203 (e.g., Tx filter) on the second side of interposer 208, the heat generated by this component can be directly dissipated through the backside, reducing the thermal load on the top side where the first circuit 204 (e.g., Rx filter) is located. This separation of high-power components improves the overall thermal balance within semiconductor device 200, thereby enhancing performance and reliability. Additionally, this configuration eliminates the need for thermal vias that would otherwise be required to conduct heat from the top side to the backside, simplifying the PCB layout and potentially reducing manufacturing costs.

In various examples, second circuit 203 is characterized by a thickness of less than or equal to 120 um. In some cases, the thickness of second circuit 203 may be in the range of 40-60 um. The process of thinning second circuit 203 involves several steps to ensure that the component maintains its functionality and reliability despite the reduced thickness. As an example, this thinning may be relative to the circuit's initial thickness, which may be in the range of 200-250 um for standard filters. In some examples, the process begins with the initial attachment of the Tx filter to interposer 208 (e.g., via flip-chip bonding). Subsequently, the Tx filter is thinned using various techniques (e.g., grinding or chemical-mechanical planarization (CMP) techniques) until the desired thickness is achieved. In addition to thinning, other manufacturing techniques may also be used to achieve the desired thickness range. Thinning the Tx filter reduces the thermal resistance, allowing for more efficient heat dissipation to ensure optimal performance. Furthermore, reducing the thickness of the Tx filter contributes to a lower profile of the semiconductor module, which is advantageous in space-constrained applications, such as mobile devices and other compact electronic systems.

In various implementations, semiconductor device 200 further includes substrate 209, which may be coupled to the second side of interposer 208. Substrate 209 may include, without limitation, PCBs, silicon wafers, ceramic substrates, and/or the like. Depending on the implementation, substrate 209 may be coupled to interposer 208 via various interconnect structures including, without limitation, metal traces, solder bumps, conductive adhesives, wire bonds, TSVs, and/or the like. In some cases, substrate 209 may include thermal pads, heat sinks, or other heat-dissipating structures to enhance thermal conductivity and facilitate efficient heat transfer away from semiconductor device 200.

In some embodiments, semiconductor device 200 further includes layer 205 coupled to second circuit 203. Layer 205 may be configured to dissipate heat generated by second circuit 203. For instance, layer 205 may include a thermally conductive layer. The term "thermally conductive layer" may refer to a layer made of materials with high thermal conductivity, designed to effectively transfer heat away from heat-generating components. Layer 205 may include, without limitation, metal foils (e.g., copper, aluminum, and others), graphite sheets, thermally conductive polymers, and/or the like. In some cases, layer 205 may be characterized by a thickness of less than or equal to 50 um.

In some examples, layer 205 is characterized by a thermal conductivity greater than or equal to 50 W/(m*K). By positioning second circuit 203 on the backside, heat generated by this high-power component can be directly transferred to layer 205, which efficiently conducts the heat away from the circuit. This configuration not only enhances thermal management but also reduces thermal stress on the top-side components, thereby improving the overall thermal balance and reliability of semiconductor device 200.

According to some embodiments, semiconductor device 200 may further include third circuit 206, which may be coupled to interposer 208. For instance, third circuit 206 includes an LNA, which may be configured to improve the sensitivity of the receiver by amplifying the received signal without significantly degrading the SNR, thereby enhancing the overall performance of the communication system. In some examples, third circuit 206 includes a MIPI controller, which may be configured to manage the data transfer between the main processor and peripheral components (e.g., cameras, displays, sensors, etc.), ensuring efficient and reliable communication.

In various implementations, semiconductor device 200 further includes fourth circuit 207, which may be coupled to interposer 208. For instance, fourth circuit 207 may include a switch, which allows for the selection between different signal paths, enabling the device to switch between antennas, frequency bands, or communication standards as needed. Fourth circuit 207 may include, without limitation, RF switches, power switches, signal switches, and/or the like.

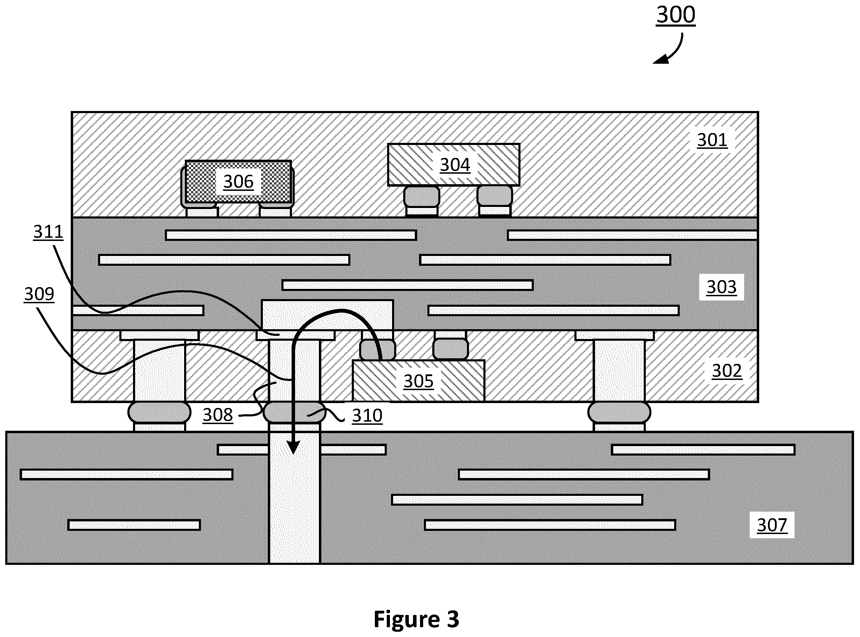

Figure 3 is a schematic cross-sectional view of a semiconductor device 300, in accordance with various embodiments of the subject technology. This diagram merely provides an example, which should not unduly limit the scope of the claims. One of ordinary skill in the art would recognize many variations, alternatives, and modifications. In various implementations, semiconductor device 300 includes at least one of first layer 301, interposer 303, second layer 302, first circuit 304, second circuit 305, SMT component 306, substrate 307, via 308, substrate pad 311, first interconnect 310, and/or the like.

Semiconductor device 300 may include a semiconductor module designed for various applications, such as RF communication, data processing, power management, and/or the like. For instance, in an RF application, the semiconductor module may be configured to manage signal transmission and reception, noise filtering, signal amplification, and/or the like. In some implementations, the semiconductor module may be a double-sided module, where components are mounted on both the top and bottom surfaces of a substrate.

As shown, semiconductor device 300 includes interposer 303, which may be configured to provide mechanical support and electrical connectivity for the components mounted on it. Interposer 303 includes a first side and a second side. The first side may be opposite the second side. First circuit 304 may be coupled to the first side of interposer 303. First circuit 304 may include an RF component. In some examples, first circuit 304 includes an Rx filter, which may be configured to isolate the desired signal from a range of received signals, ensuring that the signal quality is maintained for further processing.

In various embodiments, first layer 301 may be coupled to first circuit 304. For instance, first layer 301 includes a first molding material, which may be configured to encapsulate first circuit 304, protecting it from physical damage, moisture, dust, and other environmental factors. The first molding material may include, without limitation, EMC, SMC, phenolic molding compounds, polyimide molding compounds, and/or the like.

In some implementations, semiconductor device 300 further includes SMT component 306, which may include, without limitation, resistors, capacitors, diodes, transistors, inductors, filters, and/or the like. In some cases, SMT component 306 may be coupled to the first side of interposer 303.

In some embodiments, second circuit 305 is coupled to the second side of interposer 303. Second circuit 305 may include an RF component. For example, second circuit 305 may include, without limitation, a Tx filter, a time-division duplexing (TDD) filter, an amplifier, and/or the like. Examples of Tx filters may include, without limitation, bandpass filters, high-pass filters, low-pass filters, SAW filters, BAW filters, FBAR filters, SMRBAW filters, SiSAW filters, TCSAW filters, dielectric filters, and/or the like. Tx filters function to shape and limit the bandwidth of the transmitted signal to ensure it complies with regulatory standards and minimizes interference with other signals. In some examples, second circuit 305 may be characterized by a thickness of less than or equal to 120 um. For instance, the thickness of second circuit 305 may be in the range of 40-60 um.

In various embodiments, second layer 302 may be coupled to second circuit 305. For instance, second layer 302 includes a second molding material, which may be configured to encapsulate second circuit 305, protecting it from physical damage, moisture, dust, and other environmental factors. The second molding material may include, without limitation, EMC, SMC, phenolic molding compounds, polyimide molding compounds, and/or the like. Depending on the implementation, the first molding material and the second molding material may be the same or different.

In various implementations, semiconductor device 300 further includes substrate 307, which may be coupled to the second side of interposer 303. Substrate 307 may include, without limitation, PCBs, silicon wafers, ceramic substrates, and/or the like. In some examples, substrate 307 is coupled to interposer 303 through first interconnect 310. First interconnect 310 may include, without limitation, metal traces, solder bumps, conductive adhesives, wire bonds, TSVs, and/or the like.

According to some embodiments, the thermal management of semiconductor device 300 relies on thermal path 309, where heat generated by components such as second circuit 305 is primarily dissipated through substrate pad 311 and/or via 308 to the motherboard (e.g., substrate 307). However, the heat dissipation through the substrate pad and via is constrained by the limited cross-sectional area available for heat flow, due to practical considerations of pad size, pad pitch, and via dimensions. This constraint can lead to increased thermal resistance, affecting the overall heat transfer capability. Additionally, the inclusion of lateral traces within the substrate (e.g., interposer 303)-which are necessary for routing the thermal path-further restricts the heat dissipation capacity due to their small cross-sectional area. As a result, maintaining optimal operating temperatures for the high-power components becomes more complex, potentially impacting the performance and longevity of semiconductor device 300.

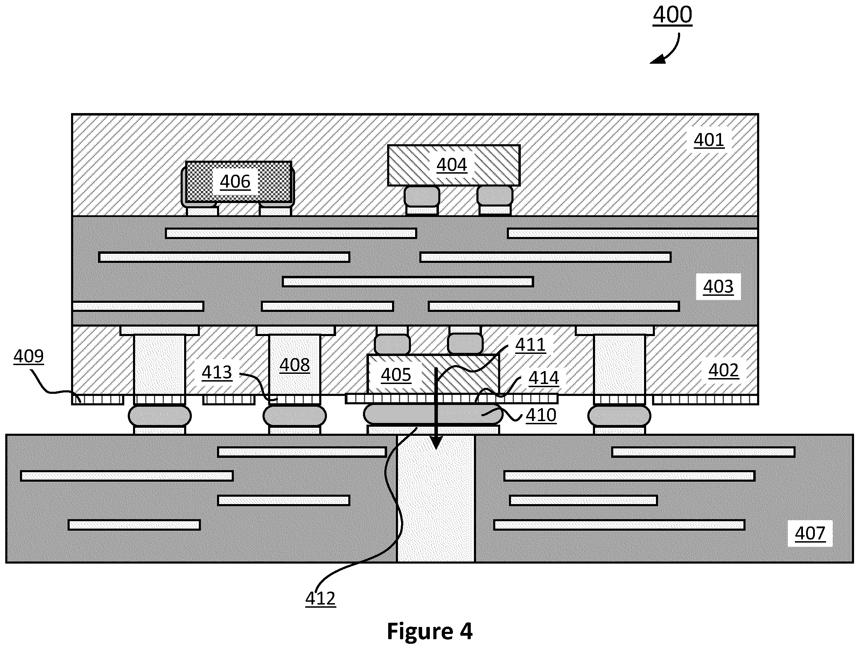

Figure 4 is a schematic cross-sectional view of a semiconductor device 400, in accordance with various embodiments of the subject technology. This diagram merely provides an example, which should not unduly limit the scope of the claims. One of ordinary skill in the art would recognize many variations, alternatives, and modifications. In various implementations, semiconductor device 400 includes at least one of first layer 401, interposer 403, second layer 402, first circuit 404, second circuit 405, SMT component 406, substrate 407, via 408, third layer 409, first interconnect 410, thermal ground paddle 412, and/or the like.

Similar to semiconductor device 300 of Figure 3, interposer 403 includes a first side and a second side. The first side may be opposite the second side. First circuit 404 may be coupled to the first side of interposer 403. First circuit 404 may include an RF component. In some examples, first circuit 404 includes an Rx filter. In various examples, first layer 401 may be coupled to first circuit 404. For instance, first layer 401 includes a first molding material, which may be configured to encapsulate first circuit 404, protecting it from physical damage, moisture, dust, and other environmental factors.

In some implementations, semiconductor device 400 further includes SMT component 406, which may include, without limitation, resistors, capacitors, diodes, transistors, inductors, filters, and/or the like. In some cases, SMT component 406 may be coupled to the first side of interposer 403.

In some embodiments, second circuit 405 is coupled to the second side of interposer 403. Second circuit 405 may include an RF component. For example, second circuit 405 may include, without limitation, a Tx filter, a TDD filter, an amplifier, and/or the like. In some examples, second circuit 405 may be characterized by a thickness of less than or equal to 120 um. For instance, the thickness of second circuit 405 may be in the range of 40-60 um. In various embodiments, second layer 402 may be coupled to second circuit 405. For instance, second layer 402 includes a second molding material, which may be configured to encapsulate second circuit 405, protecting it from physical damage, moisture, dust, and other environmental factors.

In various implementations, semiconductor device 400 further includes substrate 407, which may be coupled to the second side of interposer 403. Substrate 407 may include, without limitation, PCBs, silicon wafers, ceramic substrates, and/or the like. In some examples, substrate 407 is coupled to interposer 403 through first interconnect 410. First interconnect 410 may include, without limitation, metal traces, solder bumps, conductive adhesives, wire bonds, TSVs, and/or the like. In some cases, substrate 407 may include thermal ground paddle 412. The term "thermal ground paddle" may refer to a dedicated area on the substrate designed to provide a thermal pathway from heat-generating components to a heat sink or thermal ground. Thermal ground paddle 412 may be made of thermally conductive materials (e.g., copper or aluminum) and serve as a thermal interface between the heat-generating components within the semiconductor device and the external thermal management system. For example, thermal ground paddle 412 may be coupled to heat sinks or other cooling mechanisms on substrate 407.

According to various embodiments, semiconductor device 400 further includes third layer 409 coupled to second circuit 405. For instance, third layer 409 may include a thermally conductive layer. Third layer 409 may include, without limitation, metal foils (e.g., copper, aluminum), graphite sheets, thermally conductive polymers, and/or the like. In some examples, third layer 409 is characterized by a thermal conductivity greater than or equal to 50 W/(m*K). The inclusion of third layer 409, with its high thermal conductivity, plays an important role in the thermal management of semiconductor device 400. This layer may be positioned to directly interface with the heat-generating components (e.g., second circuit 405), allowing for efficient heat transfer away from the components. The high thermal conductivity of third layer 409 ensures that heat is rapidly conducted through the layer, minimizing the temperature rise within the heat-generating components. The process of integrating third layer 409 may include techniques such as lamination, bonding, or coating, ensuring strong adhesion and minimal thermal resistance at the interfaces.

Depending on the implementation, third layer 409 may be patterned to cover the backside of second circuit 405. This patterning process involves creating specific geometries on the thermally conductive layer to align with the shape and position of second circuit 405. This ensures that the heat generated by second circuit 405 is efficiently transferred to third layer 409. For instance, third layer 409 is characterized by a first pattern. The term "pattern" may refer to a specific arrangement or design of structures on a layer, designed to achieve a particular function. Examples of patterns may include, without limitation, conductive pathways, geometric shapes, or layouts that optimize thermal and electrical performance.

In some examples, third layer 409 comprises signal pad 413 and thermal pad 414 separated by the first pattern. The term "signal pad" may refer to an area on a substrate or layer used for making electrical connections to circuits or components, which may include contact points for wire bonding, soldering, or other electrical interfaces. The term "thermal pad" may refer to an area on a substrate or layer designed to facilitate heat transfer away from heat-generating components, which may include regions where thermally conductive materials are applied to improve heat dissipation. Examples of thermal pads may include, without limitation, copper areas for heat sinks, thermally conductive adhesives, and interface regions for cooling mechanisms. The separation of signal pads 413 and thermal pads 414 within the patterned third layer 409 optimizes the design by preventing electrical interference between the thermal management structures and the signal pathways. This separation ensures that the thermal management system does not adversely affect the electrical performance of semiconductor device 400, maintaining signal integrity and reducing the risk of crosstalk.

In various embodiments, substrate 407 is coupled to third layer 409 (e.g., thermal pad 414) through first interconnect 410. For instance, first interconnect 410 may be patterned to be placed over third layer 409 and soldered to a motherboard (e.g., thermal ground paddle 412), providing a direct thermal path 411 for heat dissipation. This direct thermal path allows heat generated by second circuit 405 to be efficiently transferred through third layer 409, first interconnect 410, and into the motherboard, where it can be dissipated over a larger surface area. By providing a large cross-sectional area for heat dissipation, thermal path 411 effectively reduces the thermal gradient and prevents overheating, which is important for maintaining the performance of high-power components (e.g., second circuit 405). Moreover, the enhanced thermal management capability supports improved RF performance by minimizing thermal-induced stress and noise within the RF components. This ensures more stable and reliable operation, allowing semiconductor device 400 to achieve higher power outputs without compromising signal integrity or device reliability.

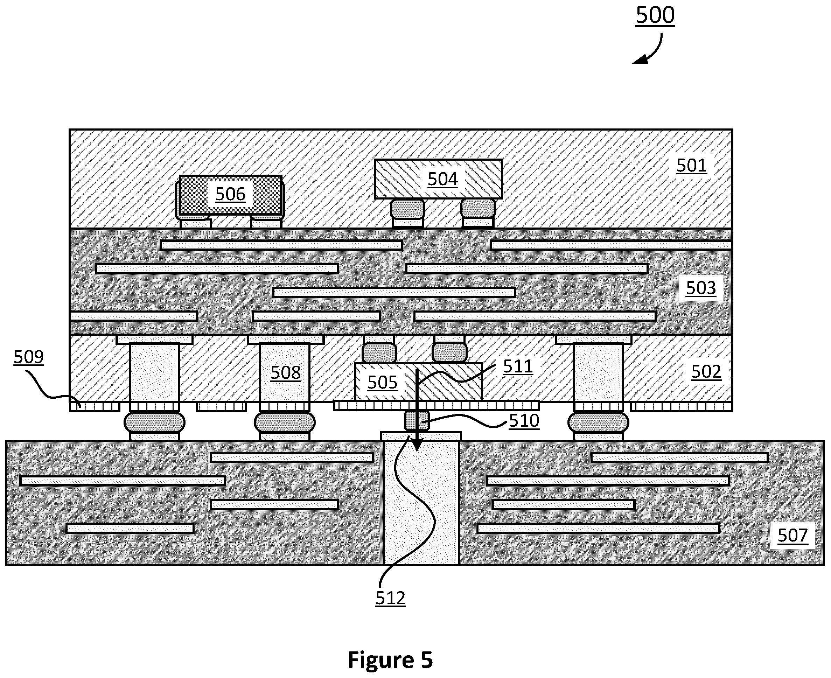

Figure 5 is a schematic cross-sectional view of a semiconductor device 500, in accordance with various embodiments of the subject technology. This diagram merely provides an example, which should not unduly limit the scope of the claims. One of ordinary skill in the art would recognize many variations, alternatives, and modifications. In various implementations, semiconductor device 500 includes at least one of first layer 501, interposer 503, second layer 502, first circuit 504, second circuit 505, SMT component 506, substrate 507, via 508, third layer 509, first interconnect 510, thermal ground paddle 512, and/or the like.

As shown, third layer 509 may be coupled to substrate 507 through first interconnect 510 under second circuit 505. For instance, first interconnect 510 includes a solder bump. The term "solder bump" may refer to a small amount of solder material used to create electrical and thermal connections between different layers or components within a semiconductor device. Examples of solder bumps may include, without limitation, lead-based solder bumps, lead-free solder bumps, copper pillar bumps, and/or the like. In various implementations, the solder bump may be positioned centrally under second circuit 505 to provide an efficient thermal path. The term "central" or "centrally" may refer to placing the solder bump near the geometric center of second circuit 505. For instance, the solder bump is positioned within 45-55% of the circuit's length and width from any edge, providing an even distribution of thermal load. The central placement of the solder bump (e.g., first interconnect 510) reduces mechanical stress and potential cracking issues that may arise from thermal expansion mismatches between second circuit 505 and thermal ground paddle 512, thereby enhancing the overall durability and robustness of semiconductor device 500.

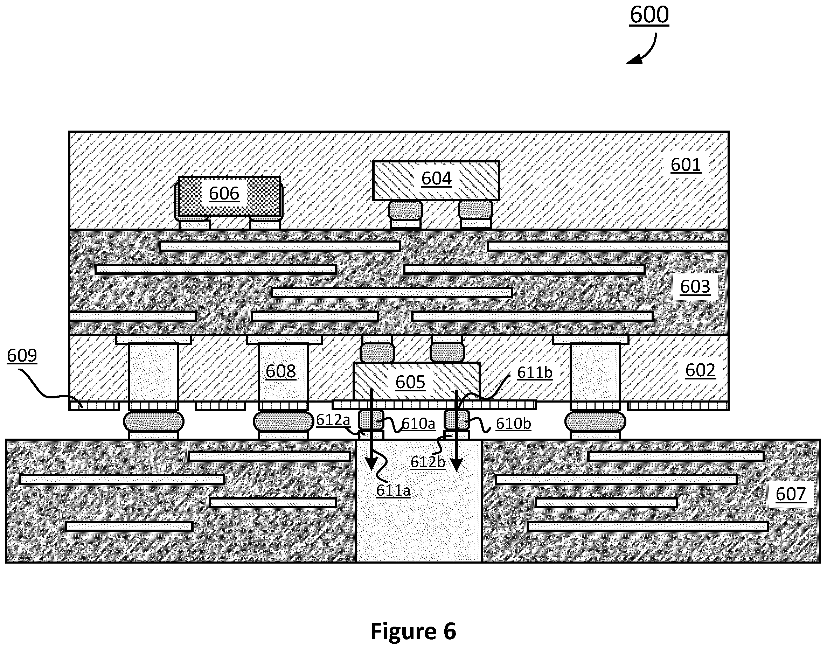

Figure 6 is a schematic cross-sectional view of a semiconductor device 600, in accordance with various embodiments of the subject technology. This diagram merely provides an example, which should not unduly limit the scope of the claims. One of ordinary skill in the art would recognize many variations, alternatives, and modifications. In various implementations, semiconductor device 600 includes at least one of first layer 601, interposer 603, second layer 602, first circuit 604, second circuit 605, SMT component 606, substrate 607, via 608, third layer 609, first interconnect 610a, second interconnect 610b, first thermal ground paddle 612a, second thermal ground paddle 612b, and/or the like.

Depending on the implementation, semiconductor device 600 may employ multiple interconnects for thermal grounding, as shown in Figure 6. For instance, third layer 609 is coupled to substrate 607 through both first interconnect 610a and second interconnect 610b under second circuit 605. Each interconnect may include a solder bump or other electrical joining materials. First interconnect 610a may be coupled to first thermal ground paddle 612a. Second interconnect 610b may be coupled to second thermal ground paddle 612b. This configuration allows for multiple thermal paths (e.g., thermal paths 611a and 611b) to efficiently transfer heat from second circuit 605 to substrate 607. This configuration increases the cumulative cross-sectional area for heat dissipation, enhancing the device's ability to manage thermal loads effectively. By employing multiple interconnects, the thermal management system can distribute the thermal load evenly across several thermal paths (e.g., thermal paths 611a and 611b), reducing the risk of localized overheating and maintaining a uniform temperature distribution within semiconductor device 600. Additionally, the use of multiple interconnects reduces the mechanical stress concentration at any single point, thus enhancing the structural integrity and durability of the device.

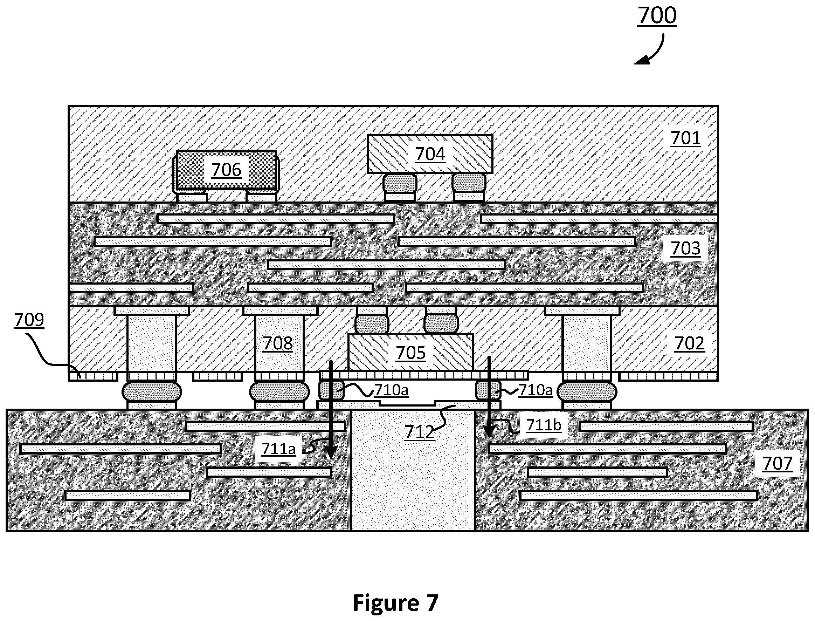

Figure 7 is a schematic cross-sectional view of a semiconductor device 700, in accordance with various embodiments of the subject technology. This diagram merely provides an example, which should not unduly limit the scope of the claims. One of ordinary skill in the art would recognize many variations, alternatives, and modifications. In various implementations, semiconductor device 700 includes at least one of first layer 701, interposer 703, second layer 702, first circuit 704, second circuit 705, SMT component 706, substrate 707, via 708, third layer 709, first interconnect 710a, second interconnect 710b, first thermal ground paddle 712a, second thermal ground paddle 712b, and/or the like.

Similar to semiconductor device 600 of Figure 6, semiconductor device 700 employs multiple interconnects (e.g., first interconnect 710a, second interconnect 710b) for thermal grounding. In various implementations, first interconnect 710a and second interconnect 710b may be positioned offset from second circuit 705 and lie on top of the molding material (e.g., second layer 702) next to second circuit 705. By placing the interconnects away from second circuit 705, the design minimizes mechanical stress concentrations, enhancing the structural integrity and durability of semiconductor device 700.

The multiple thermal paths (e.g., thermal paths 711a and 711b) facilitated by first interconnect 710a and second interconnect 710b ensure efficient heat dissipation. The heat generated by second circuit 705 is conducted through third layer 709, into the interconnects, and finally transferred to the thermal ground paddles 712a and 712b on substrate 707. These thermal paths increase the cumulative cross-sectional area for heat dissipation, enhancing the device's ability to manage thermal loads effectively.

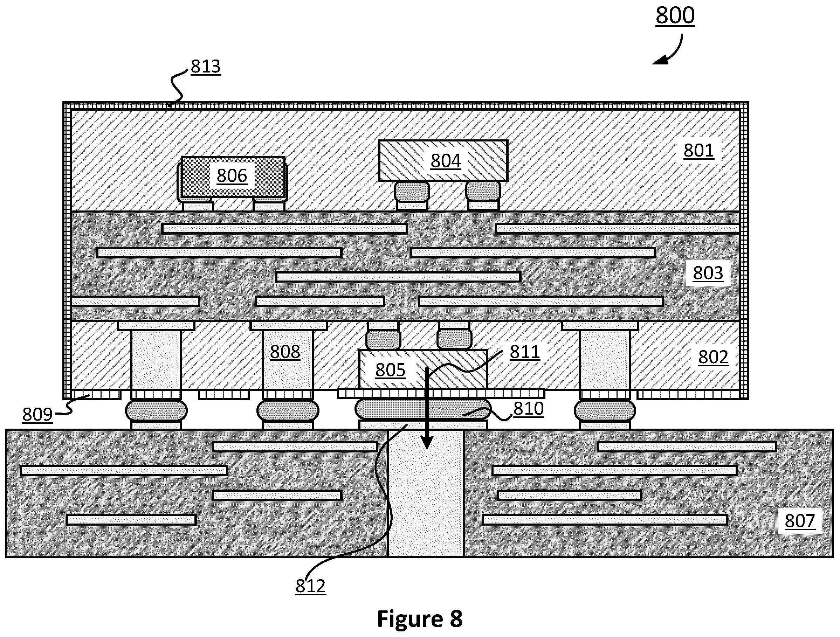

Figure 8 is a schematic cross-sectional view of a semiconductor device 800, in accordance with various embodiments of the subject technology. This diagram merely provides an example, which should not unduly limit the scope of the claims. One of ordinary skill in the art would recognize many variations, alternatives, and modifications. In various implementations, semiconductor device 800 includes at least one of first layer 801, interposer 803, second layer 802, first circuit 804, second circuit 805, SMT component 806, substrate 807, via 808, third layer 809, first interconnect 810, thermal ground paddle 812, fourth layer 813, and/or the like.

As shown, semiconductor device 800 further includes fourth layer 813. In some examples, fourth layer 813 may be coupled to first layer 801 and/or third layer 809. Fourth layer 813 may be configured to provide electromagnetic interference (EMI) shielding for first circuit 804 and/or second circuit 805. For instance, the term "EMI shielding" may refer to the use of materials or structures designed to block or attenuate electromagnetic fields to protect sensitive electronic components from interference. Fourth layer 813 may include, without limitation, metal foils, conductive fabrics, metalized films, conductive coatings, and/or the like.

Fourth layer 813 may function as an EMI shield to protect sensitive electronic components (e.g., first circuit 804 and second circuit 805) from external electromagnetic interference and to prevent these components from emitting electromagnetic radiation that could interfere with other nearby electronics. In various examples, fourth layer 813 may be positioned around the sides of the semiconductor module to create a protective barrier, ensuring stable and reliable operation of semiconductor device 800.

In some cases, fourth layer 813 may be coupled to third layer 809, allowing the EMI shield to cover and protect the bottom side of the semiconductor module. This comprehensive coverage not only shields the entire module from EMI but also enhances thermal management by providing an additional path for heat dissipation. Additionally, the EMI shielding provided by fourth layer 813 minimizes the risk of crosstalk and signal degradation within semiconductor device 800. By reducing electromagnetic interference, the device can achieve better performance and higher signal integrity. This is beneficial in applications where the semiconductor device is operating in environments with high electromagnetic noise or in close proximity to other electronic devices.

While the above is a full description of the specific embodiments, various modifications, alternative constructions and equivalents may be used. Therefore, the above description and illustrations should not be taken as limiting the scope of the subject technology which is defined by the appended claims.

## Claims

1. A semiconductor device comprising:
an interposer comprising a first side and a second side, the first side being opposite the second side;
a first circuit coupled to the first side, the first circuit comprising a first radio frequency (RF) component;
a second circuit coupled to the second side, the second circuit comprising a second RF component;
a first layer coupled to the first circuit, the first layer comprising a first molding material; and
a second layer coupled to the second circuit, the second layer being configured to dissipate heat generated by the second circuit.

2. The semiconductor device of claim 1, wherein the second layer is **characterized by** a thermal conductivity greater than or equal to 50 W/(m*K).

3. The semiconductor device of any of the previous claims, wherein the second circuit is **characterized by** a thickness of less than or equal to 120 um.

4. The semiconductor device of any of the previous claims, further comprising a substrate coupled to the second layer through a first interconnect,
in particular,
wherein the first interconnect comprises a solder bump.

5. The semiconductor device of any of the previous claims, wherein the second layer is **characterized by** a first pattern, the second layer comprises a signal pad and a thermal pad separated by the first pattern.

6. The semiconductor device of any of the previous claims, wherein the second layer is **characterized by** a thickness of less than or equal to 50 um,
and/or
wherein the second layer comprises a copper foil.

7. A semiconductor device comprising:
an interposer comprising a first side and a second side, the first side being opposite the second side;
a first circuit coupled to the first side;
a second circuit coupled to the second side;
a first layer coupled to the first circuit, the first layer comprising a first molding material;
a second layer coupled to the second circuit, the second layer comprising a second molding material; and
a third layer coupled to the second circuit, the third layer being configured to dissipate heat generated by the second circuit.

8. The semiconductor device of claim 7, wherein the second circuit comprises a radio frequency (RF) component,
and/or
wherein the second layer is **characterized by** a first pattern, the second layer comprises a signal pad and a thermal pad separated by the first pattern.

9. The semiconductor device of any of claims 7 or 8, further comprising a substrate coupled to the second layer through a first interconnect.

10. The semiconductor device of any of claims 7 to 9, wherein the second circuit comprises a transmit filter.

11. The semiconductor device of any of claims 7 to 10, further comprising a fourth layer coupled to the first layer and the third layer, the fourth layer is configured to provide electromagnetic interference (EMI) shielding for the first and second circuits.

12. The semiconductor device of any of the previous claims, further comprising a surface-mount technology (SMT) component coupled to the first side.

13. A semiconductor device comprising:
an interposer comprising a first side and a second side, the first side being opposite the second side;
a first circuit coupled to the first side, the first circuit comprising a first radio frequency (RF) component ;
a second circuit coupled to the second side, the second circuit comprising a second RF component;
a first layer coupled to the first circuit, the first layer comprising a first molding material;
a second layer coupled to the second circuit, the second layer comprising a second molding material; and
a third layer coupled to the second layer, the third layer being configured to dissipate heat generated by the second circuit.

14. The semiconductor device of claim 13, wherein the second circuit is **characterized by** a thickness of less than or equal to 120 um.

15. The semiconductor device of any of claims 13 or 14, wherein the second layer is **characterized by** a thermal conductivity greater than or equal to 50 W/(m*K),
and/or
wherein the third layer is **characterized by** a thickness of less than or equal to 50 um.
